# EUROPÄISCHE PATENTANMELDUNG

(11) **EP 1 040 874 A2**
(43) Veröffentlichungstag der Anmeldung: **04.10.2000**
(21) Anmeldenummer: 00102670.7
(22) Anmeldetag: 09.02.2000
(51) Int. Cl.: B05D 5/00, B05D 5/04

(54) **Strukturierte flüssigkeitsabweisende Oberflächen mit ortsdefinierten flüssigkeitsbenetzenden Teilbereichen**

(30) Priorität: 29.03.1999 DE 19914007
(71) Anmelder: CREAVIS Gesellschaft für Technologie und Innovation mbH, 45764 Marl (DE)
(72) Erfinder: Hommes, Peter Dr., 45657 Recklinghausen (DE); Schleich, Bernhard Dr., 45657 Recklinghausen (DE)

(57) **Zusammenfassung**

Die vorliegende Erfindung betrifft strukturierte Oberflächen mit Erhebungen einer mittleren Höhe von 50 nm bis 10 nm und einem mittleren Abstand von 50 nm bis 10 nm, einer Oberflächenenergie des unstrukturierten Materials von weniger als 35 mN/m und flüssigkeitsbenetzenden Teilbereichen und Verfahren zur Herstellung solcher Oberflächen.

Erfindungsgemäße, strukturierte Oberflächen können zur Herstellung von Probenträgern für die instrumentelle Analytik, von Probenträgern mit Flüssigkeitsleitsystemen (Mikrofluidik), als strukturierter Reaktionsort für Reagenzien und Analyten für diagnostische Systeme (Lab on Chip) oder zur Herstellung von Nano- oder Mikrotiter-Probenträgern verwendet werden.

## Beschreibung

Die vorliegende Erfindung betrifft strukturierte Oberflächen aus einem Material mit einer mittleren bis geringen Oberflächenenergie, die ortsdefiniert flüssigkeitsbenetzende Teilbereiche aufweisen.

Weiterhin betrifft die vorliegende Erfindung Verfahren zur Herstellung dieser Oberflächen und deren Verwendung.

Gegenstände mit schwer benetzbaren Oberflächen weisen eine Reihe von interessanten und wirtschaftlich wichtigen Merkmalen auf. So sind sie leicht zu reinigen und bieten Rückständen und Flüssigkeiten wenig Halt.

Oberflächen, von denen Flüssigkeiten wie Wasser leicht ablaufen, müssen entweder sehr hydrophil oder hydrophob sein. Hydrophile Oberflächen besitzen geringe Kontaktwinkel z. B. mit Wasser; dies bewirkt eine rasche Verteilung der Flüssigkeit auf der Oberfläche und schließlich ein schnelles Ablaufen des so entstandenen Flüssigkeitsfilms von der Oberfläche.

Hydrophobe Oberflächen dagegen sorgen durch einen großen Kontaktwinkel mit Flüssigkeiten wie Wasser für eine Tropfenbildung. Es werden üblicherweise Fortschreitwinkel von bis zu 120°-130° erreicht.

Der Einsatz von hydrophoben Materialien wie perfluorierten Polymeren zur Herstellung von hydrophoben Oberflächen ist bekannt; eine Weiterentwicklung dieser Oberflächen besteht darin, die Oberflächen im µm bis nm-Bereich zu strukturieren. Hierdurch lassen sich Fortschreitwinkel von bis zu 150-160° realisieren. Es wird eine deutlich stärkere Tropfenbildung beobachtet und im Unterschied zu glatten Oberflächen können Tropfen auf wenig geneigten Oberflächen leicht abrollen.

US-PS 55 99 489 offenbart ein Verfahren, bei dem eine Oberfläche durch Beschuß mit Partikeln einer entsprechenden Größe und anschließender Perfluorierung besonders wasserabweisend ausgestattet werden kann.

Ein anderes Verfahren beschreiben H. Saito et al. in Surface Coating International 4, 1997, S. 168 ff. Hier werden Partikel aus Fluorpolymeren auf Metalloberflächen aufgebracht, wobei eine stark erniedrigte Benetzbarkeit der so erzeugten Oberflächen gegenüber Wasser und eine erheblich reduzierte Vereisungsneigung festgestellt wurde.

In US-PS 33 54 022 und WO 96/04123 sind weitere Verfahren zur Erniedrigung der Benetzbarkeit von Gegenständen durch topologische Veränderungen der Oberflächen beschrieben. Hier werden künstliche Erhebungen bzw. Vertiefungen mit einer Höhe von ca. 5 bis 1000 µm und einem Abstand von ca. 5 bis 500 µm auf hydrophobe oder nach der Strukturierung hydrophobierte Werkstoffe aufgebracht. Oberflächen dieser Art führen zu einer schnellen Tropfenbildung, wobei die abrollenden Tropfen Schmutzteilchen aufnehmen und somit die Oberfläche reinigen. Angaben über ein Aspektverhältnis der Erhebungen sind nicht vorhanden.

Die oben vorgestellten Verfahren ermöglichen die Herstellung von vollständig und lückenlos flüssigkeits- und/oder schmutzabweisenden Oberflächen. Dies ist aber häufig nicht erwünscht, sondern es besteht der Wunsch, Oberflächen, die flüssigkeitsabweisende und flüssigkeitsbenetzende Bereiche aufweisen, herzustellen. Oberflächen mit solch einer "intelligenten" Struktur werden z.B. in WO 94/27719 beschrieben. Hier wird ein Verfahren zur Herstellung von hydrophoben Oberflächen mit hydrophilen und funktionalisierten Bereichen offenbart, wobei diese Bereiche strahlenchemisch hydrophiliert und anschließend naßchemisch funktionalisiert werden. Oberflächen dieser Art besitzen bis zu 10000 funktionalisierte Bereiche pro cm² und werden in der biologischen Analytik, speziell in der DNA-Sequenzierung, eingesetzt. Die auf den funktionalisierten Bereichen adhärierten Flüssigkeitsmengen sind mit 50 pl bis 2 µl sehr klein und können daher nur noch von einem Automaten aufgetragen werden.

Die chemische Hydrophilierung mit anschließender Funktionalisierung reicht für ein ortsdefiniertes Aufteilen von Flüssigkeiten oft nicht aus; erwünscht wären Oberflächen mit einem sehr großen Unterschied im Adhäsionsverhalten bzw. im Kontaktwinkel von flüssigkeitsabweisenden und flüssigkeitsbenetzenden Bereichen.

Dies gilt insbesondere dann, wenn aufgebrachte Lösungen eingeengt werden sollen, und das dabei entstehende Konzentrat bzw. die gelöste Substanz sich weiterhin an einem definierten Ort befinden soll.

Der vorliegenden Erfindung lag daher die Aufgabe zugrunde, technische Oberflächen zu entwickeln, die ortsdefiniert flüssigkeitsabweisende und flüssigkeitsbenetzende Bereiche aufweisen, wobei die flüssigkeitsabweisenden Bereiche gegenüber Flüssigkeiten wie Wasser oder Flüssigkeiten mit niedriger Oberflächenspannung einen sehr hohen Randwinkel aufweisen und so das Ablaufen dieser Flüssigkeiten in die flüssigkeitsbenetzenden Bereiche begünstigen.

Es wurde gefunden, daß Flüssigkeiten auf strukturierten Oberflächen mit Erhebungen einer bestimmen Höhe und Abstand sowie einer Oberflächenenergie des unstrukturierten Materials von weniger als 35 mN/m schnell und sauber in ortsdefinierte Teilbereiche der Oberfläche ablaufen bzw. sich dort sammeln, sofern diese Teilbereiche flüssigkeitsbenetzende Eigenschaften aufweisen.

Das Ablaufen der Flüssigkeiten erfolgt bei den erfindungsgemäßen Oberflächen bereits bei leichter Erschütterung oder leichter Neigung der Oberfläche bzw. eines entsprechenden Gegenstands um wenige Grad.

Gegenstand der vorliegenden Erfindung sind daher strukturierte Oberflächen, die Erhebungen mit einer mittleren Höhe von 50 nm bis 10 nm und einen mittleren Abstand von 50 nm bis 10 nm zueinander, eine Oberflächenenergie des unstrukturierten Materials von weniger als 35 mN/m und flüssigkeitsbenetzende Teilbereiche aufweisen.

Ein weiterer Gegenstand der vorliegenden Erfindung sind Verfahren zur Herstellung der erfindungsgemäß strukturierten Oberflächen. In einer Ausführungsform können Oberflächen mit einer Oberflächenenergie von weniger als 35 mN/m mechanisch oder lithographisch mit Erhebungen und flüssigkeitsbenetzenden Teilbereichen ohne Erhebungen versehen werden.

Die Teilbereiche ohne Erhebungen sind flache Flächen ohne die Erhebungen der strukturierten Oberfläche. Sie können durchaus kleine Strukturen aufweisen, die jedoch nicht die Abmessungen der Erhebungen, wie in den Ansprüchen definiert, aufweisen. Sollten die Teilbereiche ohne Erhebungen kleine Strukturierungen besitzen, so erreichen diese höchstens 10 % der Höhe der Erhebungen der strukturierten Oberfläche. Die Teilbereiche ohne Erhebungen oder "flachen Teilbereiche" können jedoch, wie noch gezeigt werden wird, auf gröberen Überstrukturen liegen.

In einem anderen Verfahren zur Herstellung der erfindungsgemäßen Oberflächen können Oberflächen mit einer Oberflächenenergie von weniger als 35 mN/m mechanisch oder lithographisch mit Erhebungen versehen werden und anschließend Teilbereiche der so erhaltenen strukturierten Oberfläche flüssigkeitsbenetzend beschichtet werden.

Die Erhebungen können, wie bereits ausgeführt, eine mittlere Höhe von 50 nm bis 10 µm und einen mittleren Abstand von 50 nm bis 10 µm zueinander aufweisen. Es sind jedoch auch andere Höhen und Abstände möglich; so kann jeweils unabhängig von einander die mittlere Höhe und der mittlere Abstand der Erhebungen 50 am bis 10 µm oder 50 nm bis 4 µm betragen. Darüber hinaus können die Erhebungen gleichzeitig eine mittlere Höhe von 50 um bis 4 µm und einen mittleren Abstand von 50 nm bis 4 µm aufweisen.

Erfindungsgemäß strukturierte Oberflächen weisen - bis auf die flüssigkeitsbenetzenden Teilbereiche - besonders hohe Randwinkel auf. Dies verhindert weitgehend die Benetzung der Oberfläche und führt zu einer raschen Tropfenbildung. Die Tropfen können bei entsprechender Neigung der Oberfläche auf den Erhebungen abrollen und auf den flüssigkeitsbenetzenden Teilbereichen adhärieren. Der rückstandsfreie Rückzug der Tropfenfront beim Einengen eines Tropfens auf der flüssigkeitsabweisenden Oberfläche ist dem Verhalten eines abrollenden Tropfens auf der flüssigkeitsabweisenden Oberfläche vergleichbar. Hier verbleiben die Rückstände auf den flüssigkeitsbenetzenden Teilbereichen.

Oberflächen im Sinne der vorliegenden Erfindung sind auf den flüssigkeitsabweisenden Bereichen hydrophob, wenn das unstrukturierte Material eine Oberflächenenergie weniger als 35 mN/m, bevorzugt 10-20 mN/m, aufweist und zusätzlich oleophob, wenn das unstrukturierte Material eine Oberflächenenergie von weniger als 20 mN/m aufweist. Diese Eigenschaft erweitert die Anwendungsbereiche der strukturierten Oberflächen auch auf Gebiete, wo sie mit ölhaltigen Flüssigkeiten oder anderen organischen Flüssigkeiten oder Lösungen mit niedriger Grenzflächenspannung in Kontakt kommen (z.B. als Probentäger in der Analytik organischer Verbindungen).

Bakterien und andere Mikroorganismen benötigen zur Adhäsion an eine Oberfläche oder zur Vermehrung an einer Oberfläche Wasser, welches an den hydrophoben Oberflächen der vorliegenden Erfindung nicht zur Verfügung steht. Erfindungsgemäß strukturierte Oberflächen verhindern das Anwachsen von Bakterien und anderen Mikroorganismen an den flüssigkeitsabweisenden Bereichen; sie sind somit auch bakteriophob und/oder antimikrobiell. Die erfindungsgemäß strukturierten Oberflächen ermöglichen jedoch unter entsprechenden Rahmenbedingungen, wie Luftfeuchtigkeit und Temperatur ein ortsdefiniertes Wachstum von Bakterien und anderen Mikroorganismen an den benetzbaren Teilbereichen. Da der zugrundeliegende Effekt nicht auf antimikrobiellen Wirkstoffen beruht, sondern auf einem physikalischen Effekt, ist eine Beeinträchtigung des Wachstums von Bakterien und anderen Mikroorganismen auf den flüssigkeitsbenetzenden Teilbereichen durch die flüssigkeitsabweisenden Bereiche z. B. durch Ausbluten und/oder Diffusion von Wirkstoffen ausgeschlossen.

Die Charakterisierung von Oberflächen bezüglich ihrer Benetzbarkeit kann über die Messung der Oberflächenenergie erfolgen. Diese Größe ist z. B. über die Messung der Randwinkel am glatten Material von verschiedenen Flüssigkeiten zugänglich (D.K. Owens, R. C. Wendt, J. Appl. Polym. Sci. 13, 1741 (1969)) und wird in mN/m (Milli-Newton pro Meter) angegeben. Nach Owens et al. bestimmt, weisen glatte Polytetrafluorethylen-Oberflächen eine Oberflächenenergie von 19.1 mN/m auf, wobei der Randwinkel (Fortschreitwinkel) mit Wasser 120 ° beträgt. Allgemein besitzen hydrophobe Materialien mit Wasser Kontakt- oder Randwinkel (Fortschreitwinkel) von über 90°. Polypropylen weist bei einer Oberflächenenergie von 29-30 mN/m (in Abhängigkeit von der molekularen Struktur) beispielsweise gegenüber Wasser Fortschreitwinkel von etwa 105° auf.

Die Bestimmung des Randwinkels bzw. der Oberflächenenergie erfolgt zweckmäßig an glatten Oberflächen, um eine bessere Vergleichbarkeit zu gewährleisten. Die Materialeigenschaften "Hydrophobie", "Flüssigkeitsabweisend" oder "Flüssigkeitsbenetzend" werden auch durch die chemische Zusammensetzung der obersten Molekülschichten der Oberfläche mitbestimmt. Ein höherer Randwinkel bzw. niedrigere Oberflächenenergie eines Materials kann daher auch durch Beschichtungsverfahren erreicht werden.

Erfindungsgemäße Oberflächen weisen an den flüssigkeitsabweisenden Bereichen höhere Randwinkel als die entsprechenden glatten Materialien bzw. die flüssigkeitsbenetzenden Bereichen auf. Der makroskopisch beobachtete Randwinkel ist somit eine Oberflächeneigenschaft, welche die Materialeigenschaften plus die Oberflächenstruktur widerspiegelt.

Die flüssigkeitsbenetzenden Bereiche der erfindungsgemäßen Oberflächen weisen niedrigere Randwinkel als die flüssigkeitsabweisenden Bereiche auf. Dies kann durch unterschiedliche Oberflächenstrukturen, einer unterschiedlichen Grenzflächenchemie oder einer Kombination von beidem auf den jeweiligen Bereichen erreicht werden:
- die flüssigkeitsbenetzenden Teilbereiche weisen die gleichen Erhebungen, jedoch eine höhere Oberflächenenergie als die übrige Oberfläche auf. Die unterschiedliche Oberflächenenergie kann durch eine unterschiedliche Grenzflächenchemie, z. B. durch Beschichtungen erreicht werden.
- die flüssigkeitsbenetzenden Teilbereiche weisen die gleiche Oberflächenchemie, jedoch unterschiedliche Erhebungen als die übrige Oberfläche auf. Die Oberflächenchemie unterscheidet sich nicht über der gesamten Oberfläche. Im Idealfall besitzen die flüssigkeitsbenetzenden Teilbereiche keine Erhebungen.
- die flüssigkeitsbenetzenden und flüssigkeitsabweisenden Bereiche weisen unterschiedliche Erhebungen und Oberflächenchemie auf. Dies bedeutet daß die flüssigkeitsbenetzenden Teilbereiche eine höhere Oberflächenenergie als die übrige Oberfläche, jeweils bestimmt am unstrukturierten Material, besitzen.

Zur Herstellung der erfindungsgemäßen Oberflächen können die verschiedensten Verfahren eingesetzt werden. Im folgenden sollen zwei Varianten vorgestellt werdein.

### Variante A)

Die unstrukturierte Oberflächen weisen zunächst eine Oberflächenenergie von weniger als 35 mN/m auf und werden mechanisch oder lithographisch mit Erhebungen der Höhe und Abstände der genannten Bereiche versehen. Annschließend können Teilbereiche der Oberfläche flüssigkeitsbenetzend beschichtet werden. Hierzu kann z.B. die strukturierte Oberfläche mit einer Maske abgedeckt werden, die die zu behandelnden Bereiche freiläßt. Die ungeschützten Bereiche können dann mit physikalischen Methoden aktiviert werden. Hier können Plasma-, Hochfrequenz- oder Mikirowellenbehandlung, elektromagnetische Strahlung wie z.B. Laser oder UV-Strahlung im Bereich 180 - 400 nm, Elektronenstrahlen oder Beflammung zum Einsatz kommen. Durch diese Methoden werden auf der Materialoberfläche thermisch oder photochemisch Radikalstellen erzeugt, die in Luft oder Sauerstoffatmosphäre schnell Hydroxy-, Hydroperoxid- oder sonstige polare und damit flüssigkeitsbenetzende funktionelle Gruppen bilden.

Dieser physikalischen Methode kann sich im zweiten Schritt noch eine chemische Modifizierung anschließen, welche die flüssigkeitsbenetzenden Eigenschaften weiter verbessert. Die funktionellen Gruppen werden dabei mit stabilen Endgruppen wie beispielsweise radikalisch polymerisierbaren Monomeren weiter umgesetzt. Ein Beispiel für solche eine chemische Modifizierung ist die radikalische Pfropfpolymerisation von Vinylmonomeren wie z.B. Acrylamid oder Acrylsäure, die durch den thermisch initiierten, radikalischen Zerfall der Hydroperoxidgruppen oberhalb von 70°C ausreichend rasch erfolgt.

In der Praxis hat sich die flüssigkeitsbenetzende Beschichtung der Teilbereiche durch elektromagnetische Strahlung bewährt.

### Variante B)

In einer weiteren Ausführungsform der vorliegenden Erfindung kann eine unstrukturierte Oberfläche mechanisch oder lithographisch mit Erhebungen versehen werden. Diese Oberfläche wird dann mit einem Material einer Oberflächenenergie von weniger als 35 mN/m beschichtet und die Beschichtung von Teilbereichen der so erhaltenen strukturierten Oberfläche mechanisch oder lithographisch wieder entfernt. Zweckmäßig wird ein unstrukturiertes Material mit einer Oberflächenenergie von mehr als 35 mN/m, bevorzugt 35-75 mN/m eingesetzt. Nach Entfernen der Beschichtung besitzen die flüssigkeitsbenetzenden Teilbereiche weitestgehend die Eigenschaften des ursprünglichen Materials.

Da insbesondere die chemischen Eigenschaften der obersten Monolagen des Materials für den Randwinkel entscheidend sind, kann gegebenenfalls eine Oberflächenmodifikation mit Verbindungen, die hydrophobe Gruppen enthalten, ausreichen. Verfahren dieser Art beinhalten die kovalente Anbindung von Monomeren oder Oligomeren an die Oberfläche durch eine chemische Reaktion, so z. B. Behandlungen mit Fluoralkylsilanen wie Dynasilan F 8261 (Sivento Chemie Rheinfelden GmbH, Rheinfelden) oder mit fluorierten Ormoceren.

Weiterhin sind Verfahren, bei denen zunächst Radikalstellen auf der Oberfläche erzeugt werden, die bei An- oder Abwesenheit von Sauerstoff mit radikalisch polymerisierbaren Monomeren abreagieren, zu nennen. Die Aktivierung der Oberflächen kann mittels Plasma, UV- oder α-Strahlung, sowie speziellen Photoinitiatoren erfolgen. Nach der Aktivierung der Oberfläche, d. h. Erzeugung von freien Radikalen können die Monomeren aufpolymerisiert werden. Ein solches Verfahren generiert eine mechanisch besonders widerstandsfähige Beschichtung.

Die Beschichtung eines Werkstoffs oder einer bereits erfindungsgemäß strukturierten Oberfläche durch Plasmapolymerisation von Fluoralkenen oder Vinylverbindungen hat sich besonders bewährt. Die Vinylverbindungen können auch ganz oder teilweise fluoriert sein.

Die flüssigkeitsabweisende Beschichung einer strukturierten oder unstrukturierten Oberfläche mit einem Material einer Oberflächenenergie von weniger als 35 mN/m kann durch Fluoralkylsilane oder z.B. durch Plasmapolymerisation von Fluoralkenen oder ganz oder teilweise fluorierten Vinylverbindungen erfolgen. Weiterhin ist der Einsatz einer HF-Hohlkathoden-Plasmaquelle mit Argon als Trägergas und C₄F₈ als Monomer bei einem Druck von ca. 0.2 mbar denkbar. Hiermit werden sogar Oberflächenenergien von unter 20 mN/m erreicht.

Außerdem kann sowohl die strukturierte als auch die unstrukturierte Oberfläche mit einer dünnen Schicht eines hydrophoben Polymeren überzogen werden. Dies kann in Form eines Lackes oder durch Polymerisation von entsprechenden Monomeren auf der Oberfläche des Gegenstandes erfolgen. Als polymerer Lack können Lösungen oder Dispersionen von Polymeren wie z. B. Polyvinylidenfluorid (PVDF) oder Reaktiviacke zum Einsatz kommen.

Für eine flüssigkeitsabweisende Beschichtung durch Polymerisation auf den Werkstoffen oder deren strukturierten Oberflächen kommen als Monomere insbesondere Fluoralkylsilane wie Dynasilan F 8261 (Sivento Chemie Rheinfelden GmbH, Rheinfelden) in Frage.

Die Entfernung von hydrophoben oder flüssigkeitsabweisenden Beschichtungen oder der Erhebungen von Teilbereichen der strukturierten Oberfläche kann wiederum mechanisch, thermisch, photoablativ oder lithographisch erfolgen. Mechanisch ist dies durch Mikrozerspanung z.B. durch Bohren oder Fräsen möglich. Die Werkzeuge können z.B. durch eine CNC-Aparatur sehr genau positioniert werden. Eine lithographische oder thermische Methode ist z.B. die Bestrahlung mit einem Laser in einem Wellenlängenbereich, in dem das Beschichtungsmaterial Energie absorbiert. Dies ist beispielsweise für Polymethylmethacrylat (PMMA) bei 193 nm der Fall, weshalb ein ArF*-Eximerlaser für die Ablation der Beschichtung hier besonders geeignet ist.

Eine besonders niedrige Oberflächenenergie ist insbesondere dann notwendig, wenn nicht nur hydrophobes, sondern auch oleophobes Verhalten gefordert ist. Dies ist insbesondere bei öligen Flüssigkeiten der Fall. Diese führen nämlich bei nichtoleophoben Oberflächen zu einer Benetzung, was die genannten Eigenschaften nachhaltig negativ beeinflußt. Für solche Anwendungen sollte die Oberflächenenergie des nicht strukturierten Materials unterhalb von 20 m/Nm, vorzugsweise bei 5 bis 20 mN/m liegen.

Wie bereits erwähnt, weisen glatte Polytetrafluorethylen-Oberflächen eine Oberflächenenergie von 19.1 mN/m auf. Mit Hexadecan als Flüssigkeit mit niedriger Oberflächenspannung beträgt der Randwinkel (Fortschreitwinkel) 49°. Oberflächen, die mit Fluroalkylsilanen wie z.B. Dynasilan F (Fa. Sivento Chemie, Rheinfelden) modifiziert wurden, weisen Oberflächenenergieen von unter 10 mN/m auf. Hier werden mit Hexadecan Fortschreitwinkel von bis zu 80° gemessen. Bei einer Oberflächenenergie von 29-30 mN/m wird der Randwinkel von Polypropylen gegenüber Hexadecan auf unter 10° geschätzt (experimentell nur schwer zu ermitteln).

Die Oberflächeneigenschaften der flüssigkeitsabweisenden Bereiche der erfindungsgemäßen Oberflächen sind von der Höhe, der Form und dem Abstand der Erhebungen abhängig.

Das Verhältnis von Höhe zu Breite der Erhebungen, das Aspektverhältnis, ist ebenfalls von Bedeutung. Die Erhebungen weisen bevorzugt ein Aspektverhältnis von 1 bis 10 und besonders bevorzugt von 1 bis 3.0 auf.

Um die niedrigen Randwinkel der flüssigkeitsabweisenden Bereiche zu erreichen, sind neben den strukturellen auch die chemischen Eigenschaften des Materials von Bedeutung. Hier ist insbesondere die chemische Zusammensetzung der obersten Monolage des Materials entscheidend. Die flüssigkeitsabweisenden Bereichen der erfindungsgemäßen Oberflächen werden daher zweckmäßig aus Materialien hergestellt, die bereits vor der Strukturierung ihrer Oberfläche hydrophobes Verhalten aufweisen. Diese Materialien beeinhalten insbesondere Poly(tetrafluorethylen), Poly(trifluoethylen), Poly(vinylidenfluorid), Poly(chlortrifluorethylen), Poly(hexafluorpropylen), Poly(perfluorpropylenoxid), Poly(2,2,3,3-tetrafluoroxetan), Poly(2,2-bis(trifluormethyl)-4,5-difluor-1,3-dioxol), Poly(fluoralkylacrylat), Poly(fluoralkylmethacrylat), Poly(vinylperfluoralkylether) oder andere Polymere aus Perfluoralkoxyverbindungen, Poly(ethylen), Poly(propylen), Poly(isobuten), Poly(isopren), Poly(4-methyl-1-penten), Poly(vinylalkanoate) und Poly(vinylmethylether) als Homo- oder Copolymere. Diese Materialien sind auch als Mischungsbestandteil eines Polymerblends einsetzbar. Weiterhin sind Mischungen von Polymeren mit Additiven denkbar, die sich beim Formungsprozeß so ausrichten, daß an der Oberfläche hydrophobe Gruppen vorherrschen. Als Additiv kommen fluorierte Wachse, z. B. die Hostaflone der Hoechst AG in Frage.

Die Strukturierung der Oberfläche kann auch nach der hydrophoben Beschichtung eines Werkstoffs durchgeführt werden. Ebenso kann die chemische Modifikation der Oberfläche durch eine flüssigkeitsabweisende Beschichtung nach der Formgebung durchgeführt werden.

Die Formgebung oder Strukturierung der Oberflächen kann durch Prägen/Walzen oder gleichzeitig beim makroskopischen Formen des Gegenstandes wie z. B. Gießen, Spritzgießen oder andere formgebende Verfahren erfolgen. Hierzu sind entsprechende Negativformen der erwünschten Struktur erforderlich.

Negativformen lassen sich industriell z. B. mittels der Liga-Technik (R. Wechsung in Mikroelektronik, 9, (1995) S. 34 ff) herstellen. Hier werden zunächst eine oder mehrere Masken durch Elektronenstrahllithographie nach den Dimensionen der gewünschten Erhebungen hergestellt. Diese Masken dienen zur Belichtung einer Photoresistschicht durch Röntgentiefenlithographie, wodurch eine Positivform erhalten wird. Die letzte Maskenbelichtung kann auch dem Einbringen der flachen, später flüssigkeitsbenetzenden Teilbereiche dienen. Die Zwischenräume im Photoresist werden anschließend durch galvanische Abscheidung eines Metalls aufgefüllt. Die so erhaltene Metallstruktur stellt eine Negativform für die gewünschte Struktur dar.

Die Belichtung einer Photoresistschicht kann auch durch Laserholographie erfolgen. Belichtet man dabei den Photoresist orthogonal mit Welleninterferenzmustern, so errzeugt man eine sogenannte Mottenaugenstruktur, wodurch eine Positivform erhalten wird. Eine weitere Maskenbelichtung kann wiederum dem Einbringen der flachen, später flüssigkeitsbenetzenden Teilbereiche dienen. Die Zwischenräume im Photoresist werden anschließend durch galvanische Abscheidung eines Metalls aufgefüllt. Die so erhaltene Metallstruktur stellt eine Negativform für die gewünschte Struktur dar.

Sind in die so erhaltene metallene Negativform noch keine flachen, später flüssigkeitsbenetzenden Teilbereiche eingebracht worden, läßt sich die Negativform mechanisch nachbearbeiten. Hier kann durch Mikrozerspanung die Struktur an gewünschten Stellen mechanisch abgetragen werden.

In einer anderen Ausführungsform der vorliegenden Erfindung sind die Erhebungen auf einer etwas groberen Überstruktur angeordnet.

Die Erhebungen weisen die oben ausgeführten Dimensionen auf und können auf einer Überstruktur mit einer mittleren Höhe von 10 nm bis 1 mm und einem mittleren Abstand von 10 nm bis 1 mm aufgebracht werden.

Die Erhebungen und die Überstruktur können gleichzeitig oder nacheinander mechanisch eingeprägt, durch lithographische Verfahren oder durch formgebende Verarbeitung aufgebracht werden.

Die Erhebungen und die Überstruktur können eine periodische Anordnung besitzen. Es sind jedoch auch stochastische Verteilungen der Dimensionen der Überstruktur und der Erhebungen, gleichzeitig oder unabhängig voneinander, zulässig. Bei stochastischen Strukturen wird die Rauhigkeit meist über Rauheitsparameter definiert. Als Kenngrößen für die erfindungsgemäßen Oberflächen seien der arithmetische Mittenrauhwert Ra, die gemittelte Rauhtiefe Rz und die maximale Rauhtiefe Rmax angegeben. Erfindungsgemäße Oberflächen können Werte für Ra von 0,2 bis 40 µm, Rz 0,1 bis 40 µm und Rmax 0,1 bis 40 µm aufweisen.

Die Formgebung bzw. -strukturierung der Oberflächen erfolgt bei Oberflächen mit Überstruktur wie bei Oberflächen mit nur einer Mikrostruktur, zweckmäßig in einem Arbeitsgang. Eine nachträgliche Hydrophobierung bzw. chemische Modifikation einer bereits erzeugten "doppelt" strukturierten Oberfläche ist selbstverständlich ebenso möglich.

Erfindungsgemäß hergestellte Oberflächen sind ab einer Strukturierung kleiner 400 nm transparent und eignen sich daher für alle Anwendungen, bei denen es auf eine hohe Transmission oder gute optische Eigenschaften ankommt. Hier ist besonders die Herstellung oder Beschichtung von Probenträgern in der optischen Analytik zu nennen.

Erfindungsgemäße Oberflächen eignen sich daher hervorragend zur Herstellung von Erzeugnissen, bei denen Flüssigkeiten auf kleine Bereiche aufgeteilt werden müssen. wie z.B. Probenträger. Weist ein Probenträger eine Oberfläche gemäß der vorliegenden Erfindung auf, so kann die Probe in einfacher Weise auf die flüssigkeitsbenetzenden Bereiche durch leichtes Erschüttern oder leichter Neigung der Oberfläche bzw. eines entsprechenden Gegenstands um wenige Grad verteilt werden oder ortsgenau durch Mikrodosierung z.B. mit einer Handpipette oder einem Pipettierautomaten appliziert werden. Lösungen können anschließend selektiv auf den flüssigkeitsbenetzenden Teilbereichen bis zur Trockene eingeengt und damit aufkonzentriert werden.

Eine andere Möglichkeit, Flüssigkeiten auf erfindungsgemäße Oberflächen aufzubringen, besteht in der ortsgenauen Applikation über Pipettierautomaten. Der Durchmesser des aufgebrachten Tropfens kann dabei den Durchmesser des flüssigkeitsbenetzenden Bereichs an Größe weit (um Faktor zwei bis hundert, vorzugsweise zwei bis fünfzig) überschreiten. Beim Einengen der Flüssigkeit ohne Sieden bleibt der sich verkleinernde Tropfen weiterhin streng an dem flüssigkeitsbenetzenden Bereich lokalisiert.

Eine bevorzugte Verwendung der erfindungsgemäßen Oberflächen sind daher Probenträger in der instrumentellen Analytik.

Die Verteilung wird noch beschleunigt, wenn die flüssigkeitsbenetzenden Bereiche nicht von einander isoliert, sondern durch ebenfalls flüssigkeitsbenetzende Kanäle oder Rinnen miteinander verbunden sind. Deshalb können die erfindungsgemäßen, strukturierten Oberflächen zur Herstellung von Probenträgern mit Flüssigkeitsleitsystemen (Mikrofluidik) verwendet werden.

Weiterhin sind Nano- oder Mikrotiter-Probenträgern eine Verwendung der erfindungsgemäßen Oberflächen. Die Nanotiter-Probenträger besitzen flüssigkeitsbenetzende Bereiche zur Aufhahme von Flüssigkeismengen unter 1 µl, die Mikrotiter-Probenträger entsprechend 1-100 µl.

Außerdem können die erfindungsgemäßen, strukturierten Oberflächen als strukturierter Reaktionsort für Reagenzien und Analyten für diagnostische Systeme (Lab on Chip) verwendet werden. Die flüssigkeitsbenetzenden Oberflächen dienen hier als Reaktionsorte, die durch flüssigkeitsabweisende Bereiche voneinander isoliert sind.

Weitere Verwendungen der erfindungsgemäßen, strukturierten Oberflächen sind die Herstellung von Probenträgern oder Speichermedien für Substanzbibliotheken in der kombinatorischen Chemie oder für die Nukleotidsynthese. Die flüssigkeitsbenetzenden Oberflächen dienen hier als Reaktionsorte, die durch flüssigkeitsabweisende Bereiche voneinander isoliert sind. Der Ort legt dabei die Zusammensetzung der benutzten chemischen Reagenzien fest. Die Probenplatten können unter gewünschten Bedingungen gelagert werden und bestimmte Reaktionsprodukte ortsaufgelöst nach Lagerung später wiedergewonnen werden.

Das nachfolgende Beispiel soll die vorliegende Erfindung näher beschreiben, ohne ihren Umfang zu beschränken.

### Beispiel:

Eine mikrostrukturierte Spritzgußprobe mit einer Mikrostruktur mit einem mittleren Abstand der Erhebungen von 5 µm, einer mittleren Höhe von 5 µm und einem Aspektverhältnis von 3 aus Polymethylmethacrylat (PMMA) wird mit Silanen (z.B. DSF 8261) hydrophobiert. Die Probe wird auf einem in XY-Richtung kontrolliert verstellbaren Tisch justiert. Mit einem ArF* Excimerlaser (z.B. LPX 100i Fa. Lambda Physik zur Abbildung der Apertur, versehen mit einem Schwarzschild Reflexions-Objektiv) werden auf einer Kreisfläche (Durchmesser 30-100 µm) mit 10-100 Pulsen (10 Hz) und einer Energiedichte von 0,5 Jcm⁻² bei einer Wellenlänge von 193 nm 1-70 µm PMMA-Material ablatiert. Dadurch wird sowohl die Struktur als auch die niedrigenergetische Oberflächenchemie lokal zerstört. Der Ort der lokalen Zerstörung wird über die Positionierung des Tisches definiert. An den ablatierten Bereichen haften Wassertropfen von bis zu ca. 3-5 mm Durchmesser.

## Patentansprüche

1. Strukturierte Oberflächen,
dadurch gekennzeichnet,
daß die Oberflächen
a) Erhebungen mit einer mittleren Höhe von 50 nm bis 10 µm und einem mittleren Abstand von 50 nm bis 10 µm,
b) eine Oberflächenenergie des unstrukturierten Materials von weniger als 35 mN/m und
c) flüssigkeitsbenetzende Teilbereiche aufweisen.

2. Strukturierte Oberflächen nach Anspruch 1,
dadurch gekennzeichnet,
daß die flüssigkeitsbenetzenden Teilbereiche keine Erhebungen aufweisen.

3. Strukturierte Oberflächen nach Anspruch 2,
dadurch gekennzeichnet,
daß die flüssigkeitsbenetzenden Teilbereiche eine höhere Oberflächenenergie als die übrige Oberfläche, jeweils bestimmt am unstrukturierten Material, aufweisen.

4. Strukturierte Oberflächen nach Anspruch 1,
dadurch gekennzeichnet,
daß die flüssigkeitsbenetzenden Teilbereiche die gleichen Erhebungen und eine höhere Oberflächenenergie als die übrige Oberfläche aufweisen.

5. Strukturierte Oberflächen nach einem der Ansprüche 1 bis 4,
dadurch gekennzeichnet,
daß die Erhebungen eine mittlere Höhe von 50 nm bis 4 µm aufweisen.

6. Strukturierte Oberflächen nach einem der Ansprüche 1 bis 4,
dadurch gekennzeichnet,
daß der mittlere Abstand der Erhebungen 50 nm bis 4 µm beträgt.

7. Strukturierte Oberflächen nach einem der Ansprüche 1 bis 4,
dadurch gekennzeichnet,
daß die Erhebungen eine mittlere Höhe von 50 nm bis 4 µm und einen mittleren Abstand von 50 nm bis 4 µm aufweisen.

8. Strukturierte Oberflächen nach einem der Ansprüche 1 bis 7,
dadurch gekennzeichnet,
daß die Erhebungen ein Aspektverhältnis von 1 bis 10 aufweisen.

9. Strukturierte Oberflächen nach einem der Ansprüche 1 bis 8,
dadurch gekennzeichnet,
daß die Erhebungen auf einer Überstruktur mit einer mittleren Höhe von 10 µm bis 1 mm und einem mittleren Abstand von 10 µm bis 1 mm aufgebracht sind.

10. Strukturierte Oberflächen nach einem der Ansprüche 1 bis 9,
dadurch gekennzeichnet,
daß das unstrukturierte Material Poly(tetrafluorethylen), Poly(trifluoethylen), Poly(vinylidenfluorid), Poly(chlortrifluorethylen), Poly(hexafluorpropylen), Poly(perfluorpropylenoxid), Poly(2,2,3,3-tetrafluoroxetan), Poly(2,2-bis(trifluormethyl)-4,5-difluor- 1,3-dioxol), Poly(fluoralkylacrylat), Poly(fluoralkylmethacrylat), Poly(vinylperfluoralkylether) oder andere Polymere aus Perfluoralkoxyverbindungen, Poly(ethylen), Poly(propylen), Poly(isobuten), Poly(isopren), Poly(4-methyl-1-penten), Poly(vinylalkanoate) und Poly(vinylmethylether) als Homo- oder Copolymer beinhaltet.

11. Verfahren zur Herstellung von strukturierten Oberflächen gemäß einem der Ansprüche 1 bis 3 und 5 bis 10,
dadurch gekennzeichnet,
daß Oberflächen mit einer Oberflächenenergie von weniger als 35 mN/m mechanisch oder lithographisch mit Erhebungen und flüssigkeitsbenetzenden Teilbereichen ohne Erhebungen versehen werden.

12. Verfahren zur Herstellung von strukturierten Oberflächen gemäß einem der Ansprüche 1 und 4 bis 10,
dadurch gekennzeichnet,
daß Oberflächen mit einer Oberflächenenergie von weniger als 35 mN/m mechanisch oder lithographisch mit Erhebungen versehen und anschließend Teilbereiche der Oberfläche flüssigkeitsbenetzend beschichtet werden.

13. Verfahren nach Anspruch 12,
dadurch gekennzeichnet,
daß die flüssigkeitsbenetzende Beschichtung der Teilbereiche durch elektromagnetische Strahlung erzeugt wird.

14. Verfahren zur Herstellung von strukturierten Oberflächen gemäß einem der Ansprüche 1 bis 9,
dadurch gekennzeichnet,
daß Oberflächen mechanisch oder lithographisch mit Erhebungen versehen, anschließend mit einem Material einer Oberflächenenergie von weniger als 35 mN/m beschichtet und die Beschichtung von Teilbereichen der so erhaltenen beschichteten, strukturierten Oberfläche mechanisch, thermisch, photoablativ oder lithographisch wieder entfernt wird.

15. Verfahren nach Anspruch 14,
dadurch gekennzeichnet,
daß die Beschichtung mit einem Material einer Oberflächenenergie von weinger als 35 mN/m durch Plasmapolymerisation von Fluoralkenen oder Vinylverbindungen erfolgt.

16. Verfahren nach Anspruch 14,
dadurch gekennzeichnet,
daß die Beschichtung mit einem Material einer Oberflächenenergie von weniger als 35 mN/m mit Fluoralkylsilanen oder Alkylsilanen erfolgt.

17. Verwendung der strukturierten Oberflächen gemäß einem der Ansprüche 1 bis 10 zur Herstellung von Probenträgern für die instrumentelle Analytik.

18. Verwendung der strukturierten Oberflächen gemäß einem der Ansprüche 1 bis 10 zur Herstellung von Probenträgern mit Flüssigkeitsleitsystemen (Mikrofluidik).

19. Verwendung der strukturierten Oberflächen gemäß einem der Ansprüche 1 bis 10 als strukturierter Reaktionsort für Reagenzien und Analyten für diagnostische Systeme (Lab on Chip).

20. Verwendung der strukturierten Oberflächen gemäß einem der Ansprüche 1 bis 10 zur Herstellung von Nano- oder Mikrotiter-Probenträgern.

21. Verwendung der strukturierten Oberflächen gemäß einem der Ansprüche 1 bis 10 zur Herstellung von Probenträgern oder Speichermedien für Substanzbibliotheken in der kombinatorischen Chemie.
